# EUROPEAN PATENT APPLICATION

(11) **EP 4 510 793 A1**
(43) Date of publication of application: **19.02.2025**
(21) Application number: 24191862.2
(22) Date of filing: 30.07.2024
(51) Int. Cl.: H05K 7/20

(54) **HEAT DISSIPATION ASSEMBLY, POWER MODULE, POWER SUPPLY SYSTEM AND VEHICLE**

(30) Priority: 16.08.2023 CN 202322212819 U
(71) Applicant: Valeo eAutomotive Shenzhen Co., Ltd, Shenzhen Guangdong 518128 (CN)
(72) Inventor: XU, Kangfa, Shenzhen, 518128 (CN); XU, Xiaoting, Shenzhen, 518128 (CN); HU, Dong, Shenzhen, 518128 (CN)
(74) Representative: Valeo Powertrain Systems

(57) **Abstract**

The present invention relates to a heat dissipation assembly, a power module, a power supply system and a vehicle. The heat dissipation assembly comprises a housing and a heat dissipation member, and the heat dissipation member is arranged in the housing in a mounting direction. The heat dissipation member comprises: a main body comprising a first bottom wall and a first accommodating space, the first accommodating space being used for accommodating a power device, the first bottom wall being configured to at least partially contact the power device, and the first bottom wall having a cooling channel on a surface opposite the first accommodating space; and a cover plate, which is connected to the first bottom wall in a sealed manner, the cover plate covering the cooling channel, and enclosing and forming a cooling medium passage therewith for a cooling medium to flow therethrough, wherein the housing comprises a second bottom wall, the second bottom wall has an opening, and the cover plate at least partially covers the opening and is flush with the second bottom wall.

## Description

### TECHNICAL FIELD

The present invention relates to a heat dissipation assembly, a power module comprising such a heat dissipation assembly, a power supply system comprising such a power module, and a vehicle comprising such a power module or such a power supply system.

### BACKGROUND

An electric or hybrid vehicle has an electric drive assembly system, which needs to be powered by a power module, such as an on-board power module. With the popularity of more and more compact products on vehicles, a requirement for integrated and compact design of power modules has also emerged.

A heat dissipation assembly is an important component in a power module, and is used for dispersing heat emitted by a power device in the power module. Generally, a power device in a power module is arranged vertically in a housing of the power module, and a part of the housing in contact with the power device is provided with a cooling circuit for dissipating heat from the power device. However, the vertical height of such an arrangement is greater, and it is not possible to satisfy requirements for an integrated and compact design.

Therefore, a new heat dissipation assembly is needed for use in a power module of a limited height, to satisfy requirements for an integrated and compact design of a vehicle, while ensuring good heat dissipation performance.

### SUMMARY

In view of the problem and requirements mentioned above, the present invention proposes a heat dissipation assembly, a power module comprising such a heat dissipation assembly, a power supply system comprising such a power module, and a vehicle comprising such a power module or such a power supply system, which solve the above problem and bring about other technical effects by adopting the following technical features.

In one aspect, the present disclosure provides a heat dissipation assembly, comprising a housing and a heat dissipation member, and the heat dissipation member is arranged in the housing in a mounting direction. The heat dissipation member comprises a main body and a cover plate. The main body comprises a first bottom wall and a first accommodating space, the first accommodating space being used for accommodating a power device, the first bottom wall being configured to at least partially contact the power device, and the first bottom wall having a cooling channel on a surface opposite the first accommodating space. The cover plate is connected to the first bottom wall in a sealed manner, the cover plate covering the cooling channel, and enclosing and forming a cooling medium passage therewith for a cooling medium to flow therethrough, wherein the housing comprises a second bottom wall, the second bottom wall has an opening, and the cover plate at least partially covers the opening and is flush with the second bottom wall.

A power device, such as a transformer or inductor, generates a high temperature during operation; therefore, it is necessary to dissipate the heat thereof. Conventionally, a cooling circuit is arranged on a housing of a power module or a heat dissipation assembly, and then a power device is mounted in the housing. However, such a method requires a power element to transfer the heat thereof to a cooling medium by means of three layers of surfaces (that is, thermally conductive adhesive + heat dissipation member bottom plate + cooling passage cover plate), and the dimension in the height direction is greater, and the heat dissipation efficiency is low. Moreover, arranging a complicated water channel circuit on the housing results in a complicated die casting process and high manufacturing costs. Such an arrangement also causes devices to be scattered with a motley criss-crossing of connecting lines, and the overall functional module is enormous; moreover, a lot of space is taken up in the housing with the result that the product housing is larger, and machining is complicated and difficult. Moreover, the overall assembly of the product is more difficult; each device must be assembled one-by-one, the procedure is complicated and the efficiency is not ideal.

Moreover, conventionally, maintenance is costly and time-consuming; during maintenance and replacement, it is necessary to remove the power device or heat dissipation member from the housing, which is very difficult and even impractical for an assembled heat dissipation assembly and power module, because the power device or heat dissipation member might be permanently soldered to the housing or integrally formed with the housing, and so impossible to remove.

According to the above features, the present disclosure provides a solution for designing heat dissipation of a power module of a limited height. An existing housing bottom plate is omitted in the height direction, a corresponding heat dissipation position of the housing bottom wall is hollowed out, and the cover plate of the heat dissipation member is jointly used as the bottom of the housing, thereby reducing the dimension in the height direction. In addition, the solution of the present disclosure separates the heat dissipation member from the housing, the heat dissipation member and the housing are respectively independent components, and are able to be detachably connected to each other; therefore, the housing may have a simple structure, without requiring a complicated die casting process or soldering process (such as wave soldering).

It must be explained that the height direction referred to in the present disclosure may also be called the mounting direction, which is defined by the direction in which the power device is mounted or fitted to the housing.

As an example, the heat dissipation assembly proposed in the present disclosure may have a dimension in the height direction reduced by several millimetres, for example, 1.5 to 3 mm. This reduced amount in height is significant for the design of the power module. Since the space to optimize intrinsic dimensions of the housing, power device, circuit board, etc. is limited, optimizing the dimension in the height direction by several millimetres allows the power module to be adapted to a more compact design requirement.

In some examples, the cover plate comprises a cover plate body and a bent part which is bent relative to the cover plate body, the cover plate body respectively covers the cooling channel and the opening, and the cover plate body is flush with the second bottom wall.

According to the above features, the cover plate body of the cover plate may completely cover the cooling channel or the opening of the housing, and is flush with the second bottom wall. It must be explained that "being flush with the second bottom wall" refers to a bottom face of the cover plate body being flush with a bottom face of the second bottom wall, so that viewed from the outside, the bottom of the heat dissipation assembly forms one flat surface.

In some examples, the bent part comprises a side wall and an edge which is bent relative to the side wall, and the edge is connected to the second bottom wall, wherein the edge is parallel to the cover plate body and is lower than the cover plate body in the mounting direction.

According to the above features, by means of the side wall and the edge, in one aspect, the bent part encloses and forms a cooling medium passage with a cooling channel, and in another aspect, the mounting height is adjusted to satisfy being flush with the second bottom wall, and provide a mounting interface.

In some examples, the edge is provided with a plurality of through holes spaced apart from each other, and the second bottom wall is provided with a threaded hole which corresponds to the through hole, wherein the edge is connected to the second bottom wall by means of a screw.

In some examples, a sealing member is provided between the bent part and the second bottom wall.

According to the above features, the sealing member may obstruct outside dust or foreign matter from passing through a gap between the heat dissipation member and the housing and entering the heat dissipation module.

In some examples, the main body further comprises a plurality of main body side walls, wherein one main body side wall is provided with an inlet to allow a cooling medium to flow in and an outlet to allow a cooling medium to flow out, and wherein the housing is provided with fluid interfaces which are respectively in fluid connection with the inlet and the outlet.

In some examples, the housing further comprises a second accommodating space for accommodating the heat dissipation member, and at least one of the plurality of main body side walls is provided with a partition plate, which extends perpendicularly to the main body side wall and is used for partitioning the second accommodating space into a plurality of sub-accommodating spaces.

According to the above features, providing the partition plate may partition the second accommodating space into a plurality of sub-accommodating spaces, convenient for arranging different elements physically separated from each other in the housing.

In some examples, the cover plate body is soldered to the first bottom wall. As an example, the cover plate body may be soldered to the first bottom wall by means of wave soldering, laser beam soldering, gas-shielded soldering, brazing, etc.

In some examples, the cooling channel is provided with a plurality of heat dissipation fins. By providing the heat dissipation fins, the heat exchange area and heat dissipation efficiency may be increased.

In another aspect, the present disclosure also provides a power module, comprising a power device and the heat dissipation assembly as described above, and the power device is accommodated in the first accommodating space. Since all the technical features of the heat dissipation assembly as described previously are comprised, the power module also has corresponding technical effects and advantages.

In another aspect, the present disclosure also provides a power supply system, characterized by comprising the power module as described above. Since all the technical features of the power module as described previously are comprised, the power supply system also has corresponding technical effects and advantages.

In another aspect, the present disclosure also provides a vehicle, characterized by comprising the power module described above or comprising the power supply system described above.

### BRIEF DESCRIPTION OF THE DRAWINGS

FIG.1 shows an exploded view of a heat dissipation assembly according to at least one embodiment of the present disclosure;
FIG.2 shows a three-dimensional drawing of a heat dissipation member according to at least one embodiment of the present disclosure;
FIG.3 shows another three-dimensional drawing of the heat dissipation member shown in FIG.2;
FIG.4 shows a three-dimensional drawing of a main body according to at least one embodiment of the present disclosure;
FIG.5 shows a three-dimensional drawing of a cover plate according to at least one embodiment of the present disclosure;
FIG.6 shows another three-dimensional drawing of the cover plate shown in FIG.5;
FIG.7A shows a top view of the heat dissipation assembly according to at least one embodiment of the present disclosure;
FIG.7B shows a sectional view taken along line A-A in FIG.7A; and
FIG.7C shows an enlarged view of area B in FIG.7B.

### DETAILED DESCRIPTION

In order to clarify the objective, technical solution and advantages of the present disclosure, the technical solution of embodiments of the present disclosure is described clearly and completely below in conjunction with the drawings accompanying particular embodiments of the present disclosure. In the drawings, identical reference numerals denote identical parts. It must be explained that the embodiments described are some, not all, of the embodiments of the present disclosure. All other embodiments obtained by those skilled in the art based on the described embodiments of the present disclosure without the need for inventive effort shall fall within the scope of protection of the present disclosure.

Unless otherwise defined, the technical or scientific terms used herein shall have the common meanings understood by those skilled in the art. "First", "second" and similar words used in the description and claims of the patent application of the present disclosure do not indicate any order, quantity or importance, being merely used to distinguish between different component parts. Likewise, words such as "a" or "one" do not necessarily represent a quantity limit. "Comprise", "include" or any other similar term means that the element or object appearing before the term covers the elements or objects and equivalents thereof listed after the term but does not exclude other elements or objects. "Connected" or "coupled" and similar words are not limited to a physical or mechanical connection, and may include an electrical connection, whether direct or indirect. "Upper", "lower", "left", "right", etc., are only used to indicate a relative positional relationship, and when the absolute position of the described object changes, the relative positional relationship might also change accordingly.

A heat generating element in a power device, such as a transformer or inductor, generates a high temperature during operation; therefore, it is necessary to dissipate the heat thereof. Conventionally, a cooling circuit is arranged on a housing of a power module, and then a heat generating element is mounted in the housing. However, arranging a complicated water channel circuit on the housing results in a complicated die casting process and high manufacturing costs. Such an arrangement also causes devices to be scattered with a motley criss-crossing of connecting lines, and the overall functional module is enormous; moreover, a lot of space is taken up in the housing with the result that the product housing is larger, and machining is complicated and difficult. Moreover, the overall assembly of the product is more difficult; each device must be assembled one-by-one, the procedure is complicated, and the efficiency is not ideal. Moreover, conventionally, maintenance is costly and time-consuming; during maintenance and replacement, it is necessary to remove the heat generating element from the housing, which is very difficult and even impractical for an assembled power module, because the heat generating element might be permanently soldered to the housing and impossible to remove.

Regarding defects of the prior art, the present disclosure proposes a heat dissipation assembly, a power module comprising the heat dissipation assembly, a power supply system comprising the power module, and a vehicle comprising the power module or the power supply system. Preferred embodiments of the heat dissipation assembly, power module, power supply system and vehicle according to the content of the present disclosure are specifically explained below in conjunction with the drawings.

The present disclosure provides a solution for designing heat dissipation of a power module of a limited height. An existing housing bottom plate is omitted in the height direction, a corresponding heat dissipation position of the housing bottom wall is hollowed out, and the cover plate of the heat dissipation member is jointly used as the bottom of the housing, thereby reducing the dimension in the height direction. In addition, the solution of the present disclosure separates the heat dissipation member from the housing, the heat dissipation member and the housing are respectively independent components, and are able to be detachably connected to each other; therefore, the housing may have a simple structure, without requiring a complicated die casting process or soldering process (such as wave soldering). In addition, a design without a heat dissipation member bottom plate is used for the heat dissipation assembly, which may reduce thermal resistance to heat transfer and lighten the weight of parts in the height direction.

Preferred embodiments of the heat dissipation assembly, power module, power supply system and vehicle according to the content of the present disclosure are specifically explained below in conjunction with the drawings.

Compared with the embodiments shown in the drawings, a feasible embodiment within the scope of protection of the present disclosure may have fewer components, another component not shown in any of the drawings, a different component, a component arranged differently, or a component connected differently, etc. Further, without departing from the concepts disclosed in the present disclosure, two or more components in a drawing may be implemented in a single component, or a single component shown in a drawing may be implemented as a plurality of separate components.

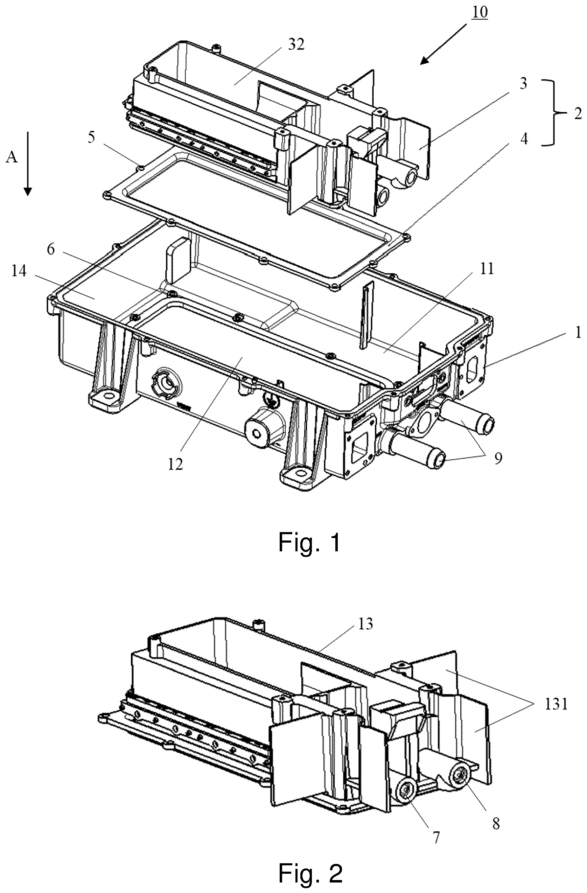

As shown in Fig. 1, the heat dissipation assembly 10 according to at least one embodiment of the present disclosure comprises a housing 1 and a heat dissipation member 2, and the heat dissipation member 2 is arranged in the housing 1 in a mounting direction A. The mounting direction A is defined as the direction from top to bottom in Fig. 1.

The housing 1 comprises a second bottom wall 11 and a plurality of side walls, and these walls enclose and form a second accommodating space 14 for accommodating the heat dissipation member 2. The second bottom wall 11 is provided with an opening 12. In the present embodiment, the opening 12 is arranged in the middle of the second bottom wall 11, and a plurality of threaded holes 6 are provided around the opening 12.

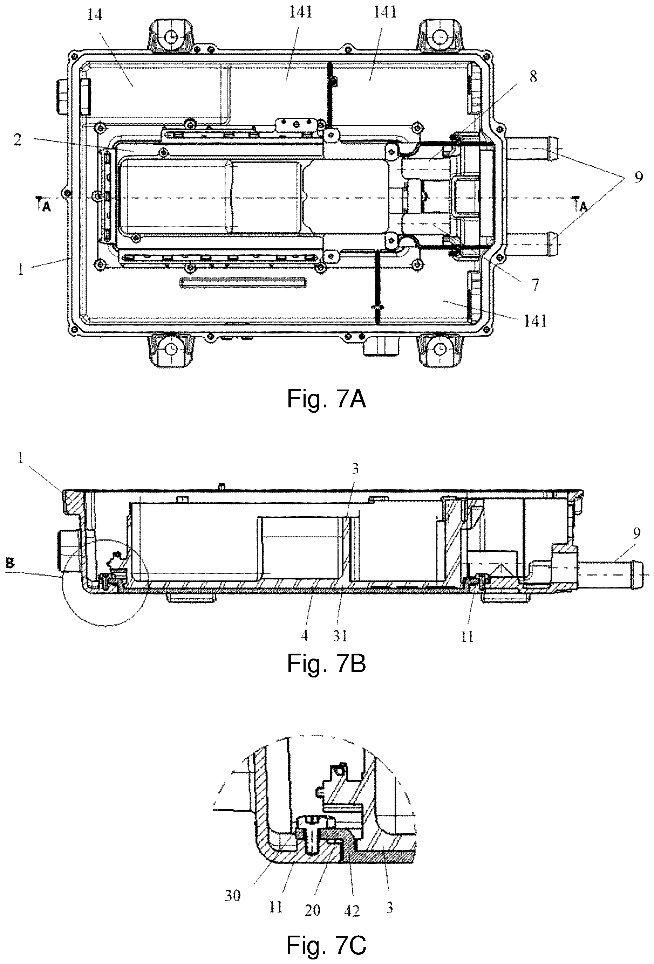

As shown in Figs. 2 to 6, the heat dissipation member 2 comprises a main body 3 and a cover plate 4, and the main body 3 is soldered to the cover plate 4, for example by wave soldering. The main body 3 may comprise a first bottom wall 31, a plurality of main body side walls 13 and a first accommodating space 32, and the first bottom wall 31 and the plurality of main body side walls 13 enclose and form the first accommodating space 32, which is used for accommodating a power device. The first bottom wall 31 is configured to at least partially contact the power device, and thus guide away heat generated by the power device. At least one of the plurality of main body side walls 13 may be provided with a partition plate 131 which extends perpendicularly to the main body side wall 13, and is used for partitioning the second accommodating space 14 into a plurality of sub-accommodating spaces 141, as shown in Fig. 7A.

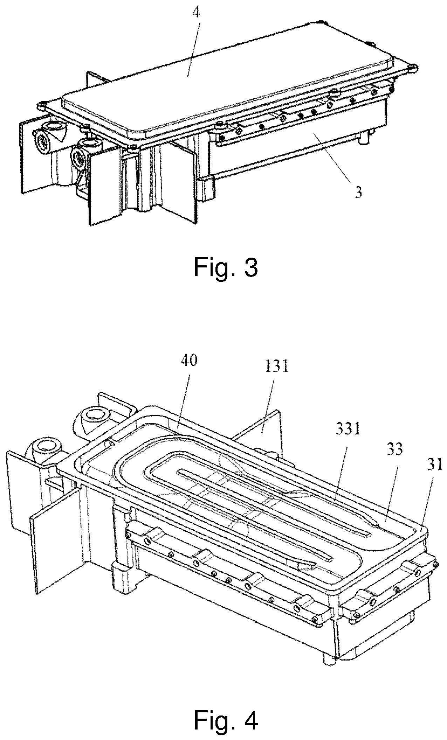

Referring to Fig. 4, the cover plate 4 is omitted to show the bottom of the first bottom wall 31. As shown in Fig. 4, the first bottom wall 31 is provided with a cooling channel 33 on a surface that is opposite the first accommodating space 32. A plurality of protruding heat dissipation fins 331 are provided in the cooling channel 33, so as to increase an area of heat exchange with a cooling medium, increasing the heat dissipation efficiency.

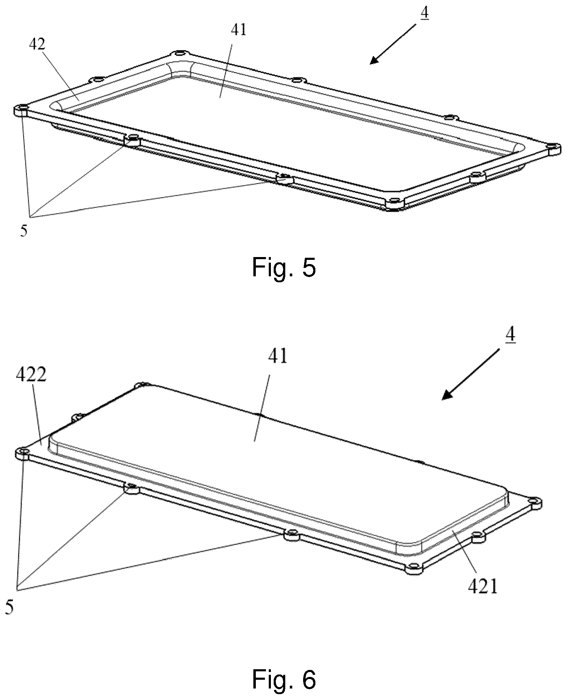

Figs. 5 and 6 show the cover plate 4 according to at least one embodiment of the present disclosure; the cover plate 4 is connected to the first bottom wall 31 in a sealed manner, and the cover plate 4 covers the cooling channel 33, and encloses and forms a cooling medium passage 40 therewith for a cooling medium to flow therethrough. Moreover, after the heat dissipation member 2 is mounted in place, the cover plate 4 at least partially covers the opening 12 and is flush with the second bottom wall 11.

As an example, the cooling medium may be water, oil or an alcohol solution, such as ethylene glycol or propylene glycol.

As shown in Figs. 5 and 6, the cover plate 4 may comprise a cover plate body 41 and a bent part 42 that is bent relative to the cover plate body 41. In the present embodiment, two opposite surfaces of the cover plate body 41 respectively cover the cooling channel 33 and the opening 12, and the cover plate body 41 is flush with the second bottom wall 11, as shown in Fig. 7B.

Again referring to Figs. 5 and 6, the bent part 42 may comprise a side wall 421 and an edge 422 that is bent relative to the side wall 421. The edge 422 is connected to the second bottom wall 11, and the edge 422 is parallel to the cover plate body 41 and is lower than the cover plate body 41 in the mounting direction A. Therefore, the side wall 421 and the cover plate body 41 form a cross section resembling a U-shape, and the edge 422 extends outward relative to the side wall 421, thus providing a mounting space.

It must be explained that, since the mounting direction A is from top to bottom, the edge 422 being lower than the cover plate body 41 in the mounting direction A can be understood as the edge 422 being higher than the cover plate body 41 or the edge 422 being above the cover plate body 41.

Regarding the mounting space, the edge 422 may be provided with a plurality of through holes 5 spaced apart from each other, corresponding to threaded holes 6 of the second bottom wall 11. Therefore, the edge 422 may be connected to the second bottom wall 11 by means of screws 30, as shown in Fig. 7C.

To ensure the sealing performance of the overall heat dissipation assembly, a sealing member 20 may be provided between the bent part 42 and the second bottom wall 11. As an example, as shown in Fig. 7C, a part of the second bottom wall 11 provided with the threaded holes 6 may be slightly higher, and the lower part may be provided with the sealing member 20. As an example, the sealing member 20 may surround the entire periphery of the bent part 42 connected to the second bottom wall 11.

In addition, to form a cooling medium circuit, one of the main body side walls 13, such as the main body side wall 13 at the rightmost side in Fig. 2, may be provided with an inlet 7 to allow a cooling medium to flow in and an outlet 8 to allow a cooling medium to flow out. Correspondingly, the housing 1 may be provided with two fluid interfaces 9. When mounted in place, the two fluid interfaces 9 are respectively in fluid communication with the inlet 7 and the outlet 8.

Therefore, during operation of the power device, the heat generated is exchanged with the cover plate body 41 in contact therewith and the cooling medium in the cooling channel 33 and guided away; compared with a conventional heat dissipation assembly, one thermally conductive medium layer is omitted, and the dimension in the height direction is reduced.

In another aspect, the present invention also proposes a power module, comprising a power device (not shown) and the heat dissipation assembly as described above. The power device may be accommodated in the first accommodating space 32. The power device, for example, may be a transformer, an inductor or a power transistor device.

In another aspect, the present invention also proposes a power supply system, comprising the power module as described above. The power supply system is used, for example, to supply power to electric or hybrid vehicles.

According to another aspect of the present disclosure, a vehicle is proposed, the vehicle comprising the power module as described above or the power supply system as described above, and having the function as described above. The vehicle may be an electrified vehicle, such as a battery electric vehicle (BEV), a hybrid electric vehicle (HEV), a plug-in hybrid electric vehicle (PHEV), a range extended EV and a fuel cell electric vehicle (FCEV). The vehicle may also be a hydrogen-powered vehicle.

Exemplary embodiments of a heat dissipation assembly, a power module, a power supply system and a vehicle of the present invention have been described in detail herein with reference to preferred embodiments. However, those of ordinary skill in the art will understand that, without departing from the concept of the present invention, various alterations and modifications may be made to the specific embodiments described above, and that various combinations of the technical features and structures proposed by the present invention may be made without exceeding the scope of protection of the present invention; the scope of protection of the present invention is defined by the attached claims.

## Claims

1. A heat dissipation assembly (10) comprising a housing (1) and a heat dissipation member (2), the heat dissipation member (2) being arranged in the housing (1) in a mounting direction (A), **characterized in that** the heat dissipation member (2) comprises:
a main body (3), which comprises a first bottom wall (31) and a first accommodating space (32), the first accommodating space (32) is used for accommodating a power device, the first bottom wall (31) is configured to at least partially contact the power device, and the first bottom wall (31) is provided with a cooling channel (33) on a surface that is opposite the first accommodating space (32); and
a cover plate (4), which is connected to the first bottom wall (31) in a sealed manner, and the cover plate (4) covers the cooling channel (33), and encloses and forms a cooling medium passage (40) therewith for a cooling medium to flow therethrough,
wherein the housing (1) comprises a second bottom wall (11), the second bottom wall (11) is provided with an opening (12), and the cover plate (4) at least partially covers the opening (12) and is flush with the second bottom wall (11).

2. The heat dissipation assembly (10) according to Claim 1, **characterized in that** the cover plate (4) comprises a cover plate body (41) and a bent part (42) which is bent relative to the cover plate body (41), the cover plate body (41) respectively covers the cooling channel (33) and the opening (12), and the cover plate body (41) is flush with the second bottom wall (11).

3. The Heat dissipation assembly (10) according to Claim 2, **characterized in that** the bent part (42) comprises a side wall (421) and an edge (422) which is bent relative to the side wall (421), and the edge (422) is connected to the second bottom wall (11), wherein the edge (422) is parallel to the cover plate body (41) and is lower than the cover plate body (41) in the mounting direction (A).

4. The heat dissipation assembly (10) according to Claim 3, **characterized in that** the edge (422) is provided with a plurality of through holes (5) spaced apart from each other, and the second bottom wall (11) is provided with a threaded hole (6) which corresponds to the through hole (5), wherein the edge (422) is connected to the second bottom wall (11) by means of a screw (30).

5. The heat dissipation assembly (10) according to Claim 4, **characterized in that** a sealing member (20) is provided between the bent part (42) and the second bottom wall (11).

6. The heat dissipation assembly (10) according to Claim 1, **characterized in that** the main body (3) further comprises a plurality of main body side walls (13), wherein one main body side wall (13) is provided with an inlet (7) to allow a cooling medium to flow in and an outlet (8) to allow a cooling medium to flow out, and wherein the housing (1) is provided with fluid interfaces (9) which are respectively in fluid connection with the inlet (7) and the outlet (8).

7. The heat dissipation assembly (10) according to Claim 6, **characterized in that** the housing (1) further comprises a second accommodating space (14) for accommodating the heat dissipation member (2), and at least one of the plurality of main body side walls (13) is provided with a partition plate (131), which extends perpendicularly to the main body side wall (13) and is used for partitioning the second accommodating space (14) into a plurality of sub-accommodating spaces (141).

8. The heat dissipation assembly (10) according to any one of Claims 2 to 5, **characterized in that** the cover plate body (41) is soldered to the first bottom wall (31).

9. The heat dissipation assembly (10) according to any one of Claims 1 to 7, **characterized in that** the cooling channel (33) is provided with a plurality of heat dissipation fins (331).

10. A power module, **characterized in that** the power module comprises a power device and the heat dissipation assembly (10) according to any one of Claims 1 to 9, and the power device is accommodated in the first accommodating space (32).

11. A power supply system, **characterized in that** the power supply system comprises the power module according to Claim 10.

12. A vehicle, **characterized in that** the vehicle comprises the power module according to Claim 10 or the power supply system according to Claim 11.
